# FASCICULE DE BREVET EUROPEEN

(11) **EP 0 354 117 B1**
(45) Date de publication et mention de la délivrance du brevet: **21.09.1994**
(21) Numéro de dépôt: 89402186.4
(22) Date de dépôt: 01.08.1989
(51) Int. Cl.: B06B 1/06, H01L 41/22

(54) **Transducteur piézoélectrique pour générer des ondes de volume**
Piezoelektrischer Wandler zur Volumenwellenerregung
Piezoelectric transducer for volume wave generation

(30) Priorité: 05.08.1988 FR 8810610
(43) Date de publication de la demande: 07.02.1990
(73) Titulaire: THOMSON-CSF, 75008 Paris (FR)
(72) Inventeur: Defranould, Philippe, F-92045 - Paris La Défense (FR); Poncot, Claude, F-92045 - Paris La Défense (FR)
(74) Mandataire: Desperrier, Jean-Louis

(56) Documents cités:
- DE-A- 2 001 468
- GB-A- 2 046 554
- US-A- 4 666 547
- PATENT ABSTRACTS OF JAPAN, vol. 3, no. 18 (E-91), 16 février 1979, page 6 E91;& JP-A-53 145 593
- MICROWAVE JOURNAL, vol. 18, no. 9, septembre 1975, pages 44-47, Dedham, US; A.SCHAER et al.: "Soldered piezoelectric transducer acoustic-wave components"

## Description

La présente invention concerne un transducteur piézoélectrique et plus particulièrement un transducteur utilisé pour générer des ondes de volume en hyperfréquences, de l'ordre du gigahertz, dans un substrat cristallin constituant ledit support. La génération des ondes de volume permet de réaliser une ligne à retard à ondes de volume, ou bien un transducteur acousto-optique, dit cellule de Bragg, pour diffracter et moduler un faisceau laser incident.

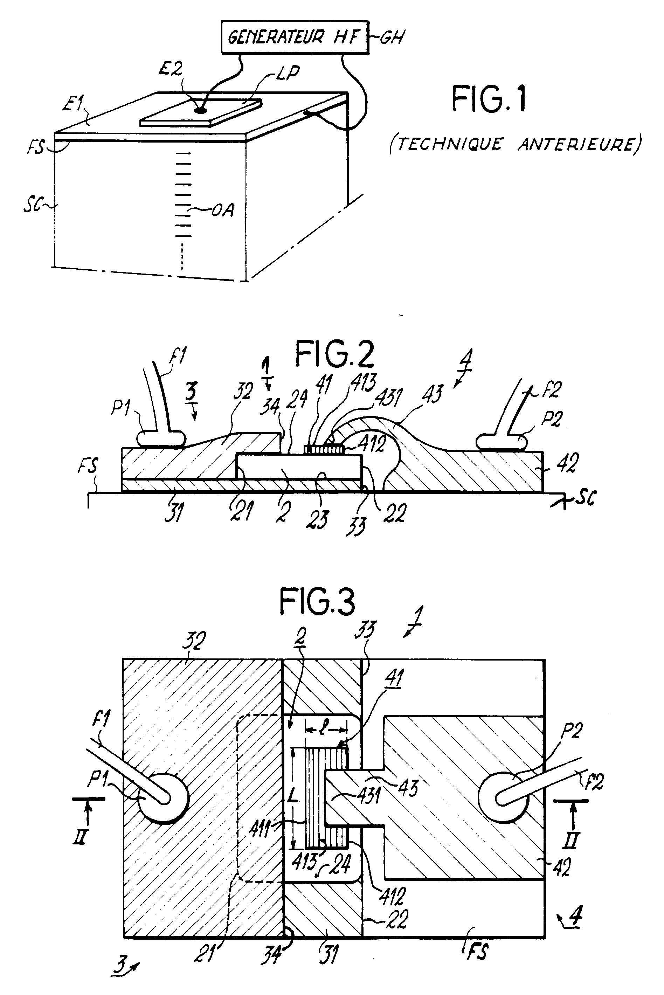

Dans la Fig. 1 annexée est représentée schématiquement une ligne à ondes de volume comprenant un substrat SC, tel qu'un barreau de corindon, et un transducteur piézoélectrique supporté par une face plane FS du substrat. Une première électrode E1 du transducteur est constituée par un plan de contact de masse qui est métallisé sur toute la face de substrat FS. Une lame mince piézoélectrique LP à fort coefficient de couplage est centrée sur l'électrode plane métallisée E1. Au centre de cette lame est déposée une seconde électrode E2. Les électrodes E₁ et E₂ sont reliées à un générateur de signal hyperfréquence GH, tel qu'un circuit d'amplification d'antenne de réception, par exemple par l'intermédiaire d'une ligne hyperfréquence à microruban d'adaptation d'impédance sur substrat en céramique, pour produire des ondes acoustiques hyperfréquence OA se propageant longitudinalement dans le substrat SC et perpendiculairement à la face FS de celui-ci.

Pour des raisons de facilité technologique et de fiabilité, la lame LP est nettement plus grande que la seconde électrode E2 qui doit être petite pour diminuer la capacité électrique du transducteur piézoélectrique et ainsi augmenter le rendement de celui-ci. Toutefois, l'admittance du transducteur ne peut être diminuée autant que désiré en raison du point ou "boule" de soudure recouvrant la seconde électrode E2 nécessaire pour relier celle-ci au générateur GH. En effet, la boule de soudure a un diamètre égal à au moins 50 µm et donc les dimensions de l'électrode E2 ne peuvent être inférieures à cette dimension.

En outre, la boule de soudure provoque par son poids des perturbations non reproductibles sur la génération des ondes acoustiques et offre une inductance de self en série relativement importante.

Lors de l'opération de soudure, l'électrode E2 ainsi que la lame LP risquent d'être endommagées.

La présente invention vise donc à remédier principalement aux inconvénients inhérents à la connexion directe par soudure de la seconde électrode en effectuant un report de connexion de cette électrode de façon à rendre indépendante sa dimension de la taille de la soudure. On obtient une région de contact effective de la seconde électrode plus petite permettant de diminuer l'admittance du transducteur piézoélectrique.

A cette fin, l'invention propose un transducteur selon la revendication 1.

Grâce au pont de liaison, dit "pont à air", la connexion de la seconde électrode est reportée sur la région de connexion. Cette région de connexion présente une surface considérablement plus grande que celle de la seconde électrode pour être soudée à un fil de connexion sans le moindre risque de détérioration de la lame piézoélectrique et de la seconde électrode. Les dimensions de la seconde électrode sont alors indépendantes de la grosseur de la soudure, et peut ainsi atteindre des dimensions nettement inférieures à 50 µm, typiquement inférieures à 30 µm. Le transducteur piézoélectrique peut être relié directement à une source hyperfréquence ayant une admittance très faible.

Selon un autre aspect de l'invention, un transducteur piézoélectrique peut être fabriqué selon quatre étapes successives suivantes, après dépôt de la région de contact de la première électrode, de la lame piézoélectrique et de la seconde électrode sur la face du support :
A) Dépôt d'une couche de résine partiellement sur la lame piézoélectrique et la seconde électrode et sur la face de support de part et d'autre du côté de lame à enjamber par ledit pont,
B) Dépôt d'une couche métallique pour recouvrir au moins la couche de résine et une portion de la face de support non recouverte par la région de contact,
C) Usinage de la couche métallique pour définir au moins le pont de liaison et la région de connexion reliée à la seconde électrode, et
D) Elimination de la couche de résine.

Comme on le verra dans la suite, un tel procédé de fabrication convient bien à la fabrication d'un ensemble de transducteurs piézoélectrique juxtaposés sur la face du support et ayant en commun une unique première région de contact d'électrode en vue de fournir un ensemble de cellules de Bragg disposées parallèlement.

D'autres avantages et caractéristiques de l'invention apparaîtront plus clairement à la lecture de la description suivante de plusieurs réalisations préférées de l'invention en référence aux dessins annexés correspondants dans lesquels :
- la Fig. 1 est une vue en perspective schématique du transducteur piézoélectrique pour ligne à ondes à volume selon la technique antérieure décrite ci-dessus ;
- la Fig. 2 est une vue en coupe verticale et longitudinale prise le long de la ligne II-II de la Fig. 3, d'un transducteur piézoélectrique selon l'invention ;
- la Fig. 3 est une vue de dessus du transducteur piézoélectrique selon l'invention ;
- les Figs. 4A, 4B, 4C et 4D sont des vues schématiques analogues à la Fig. 2 illustrant respectivement quatre étapes de fabrication du transducteur relatives principalement à la réalisation d'un pont de liaison ; et
- la Fig. 5 est une vue en perspective schématique d'un ensemble de transducteurs piézoélectrique selon l'invention, juxtaposés sur une face supérieure d'un substrat cristallin.

En référence aux Figs. 2 et 3, un transducteur piézoélectrique 1 selon l'invention est supporté par l'une FS des petites faces transversales terminales planes d'un substrat cristallin SC, tel qu'un barreau de corindon, pour constituer une ligne à ondes de volume. Le transducteur piézoélectrique 1 comprend une lame piézoélectrique rectangulaire 2 située sensiblement au-dessus du centre de la face FS du substrat. La lame est nettement plus petite que la face FS. Une première électrode 3, dite électrode de masse, du transducteur 1 est située en majeure partie latéralement à un premier grand côté 21 de la lame 2, à gauche dans les Figs. 1 et 2. Un second ensemble de connexion 4 du transducteur 1 est situé en majeure partie latéralement à un second grand côté 22 de la lame 2, à droite dans les Figs. 1 et 2.

La première électrode 3 est constituée par une région de contact plane rectangulaire 31 qui est disposée sur la face de substrat FS partiellement sous toute la lame 2, et par une région de connexion 32 entre la région de contact 31 et un premier fil de connexion f1. La région de contact 31 est une sous-couche métallique, par exemple en or, ayant une épaisseur de 0,05 µm environ. La sous-couche de région de contact 31 ne recouvre que la partie de gauche de la face de substrat FS jusqu'au grand côté 22 de la lame piézoélectrique 2. La région 31 est en contact avec toute la face inférieure 23 de la lame 2 et offre un bord longitudinal 33 coplanaire avec le côté de lame 22 et perpendiculaire à la face FS. La région de connexion 32 de la première électrode 3 est par exemple également en or, et recouvre la partie de gauche de la région de contact 31 latérale au grand côté de lame 21 ainsi qu'une partie de la face supérieure 24 de la lame 2, du côté 21, pour former un bord 34 sensiblement vertical à la lame 2. L'épaisseur de la région de connexion 32 est égale à 0,4 µm environ. Sensiblement au centre de la face supérieure de la partie de la région de connexion 32 recouvrant la région de contact 31, une petite pastille de soudure P1 relie une extrémité du fil f1 également en or à la région de connexion 32.

La lame piézoélectrique 2 est en matériau piézoélectrique tel que nobiate de lithium LiNbO₃, ou oxyde de zinc ZnO, et a typiquement une épaisseur de 0,3 µm. Le côté 22 de la lame est usiné simultanément avec le bord de gauche 33 de la région de contact de masse 31 afin que ce côté et ce bord soient alignés perpendiculairement à la face de substrat FS.

L'ensemble de connexion 4 comprend une seconde électrode 41 disposée sur la partie de droite de la face supérieure 24 de la lame piézoélectrique 2, une région de connexion 42 située sur la partie de droite de la face de substrat FS, et un pont conducteur étroit 43 reliant l'électrode 41 et la région 42 et enjambant le côté de lame 22 ainsi que le bord 33 de la région de contact 31 de la première électrode 3.

Selon un exemple de réalisation, la seconde électrode 41 est une lamelle métallique, par exemple en aluminium, et a une longueur L de l'ordre de ou inférieure à 30 µm et une largeur ℓ de l'ordre de 20 µm. Un grand côté longitudinal 411 de l'électrode 41 est sensiblement colinéaire à l'axe longitudinal de la lame 2, et la largeur ℓ de l'électrode 41 est égale sensiblement au tiers de la largeur de la lame 2, de sorte que l'autre grand côté longitudinal 412 de l'électrode 41 soit en retrait du côté 22 sur la face de lame 24. Comme la lame 2, l'électrode 41, le pont 43 et la région de connexion 42 sont centrés et alignés le long d'un grand axe II-II de la face de substrat FS. Typiquement, la longeur L de l'électrode 41 est sensiblement inférieure à la moitié de la longueur de la lame 2, la largeur constante du pont 43 est sensiblement inférieure à la longueur L de l'électrode 41, et la longueur de la région de connexion 42 est sensiblement égale à celle de la lame 2, comme montré à la Fig.3.

Le pont de liaison 43 est une partie mince, en surplomb, de largeur constante, formant une partie monolithique avec la région de connexion 42. Le pont 43 a une épaisseur typiquement de l'ordre du quart de l'épaisseur de la région 42. Le chant extrême 431 du pont 43 est parallèle à la face de substrat FS et est accolé sur la face supérieure 413 de l'électrode 41, en longeant le côté de droite 412 de celle-ci.

La région de connexion 42 est rectangulaire et est reliée à l'extrémité d'un second fil de connexion f2 en or par exemple, par l'intermédiaire d'une pastille de soudure P2 qui est déposée sur la face supérieure de la région 42. Pour l'application envisagée à une ligne à ondes de volume, les fils f1 et f2 relient le transducteur piézoélectrique 1 à un générateur de signal électrique hyperfréquence.

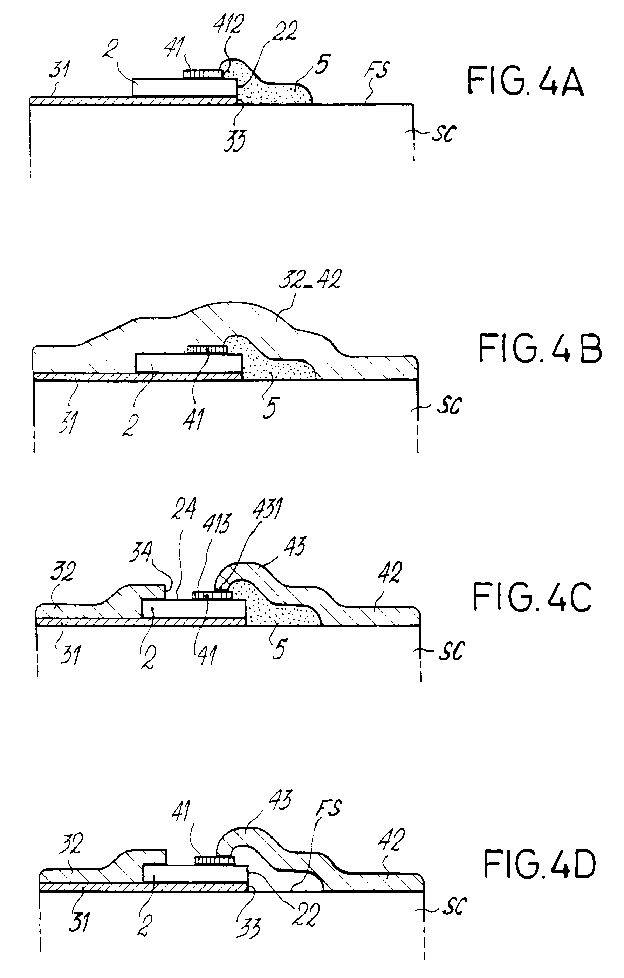

Après métallisation de la première région de contact 31, fixation de la lame piézoélectrique 2 et métallisation de la seconde électrode 41, la réalisation du pont de connexion 43, dit "pont à air", comporte principalement quatre étapes successives, illustrées aux Figs. 4A à 4D, et qui sont les suivantes :
A) Une couche de résine photosensible 5 est déposée latéralement à droite de la seconde électrode 41, la lame piézoélectrique 2 et la région de contact 31 et recouvre les côtés 412 et 22 et le bord 33 et une portion de la face de substrat FS sur une largeur supérieure au pont 43 à réaliser, comme montré à la Fig. 4A.
B) Une couche métallique 32,42 en or ayant une forte épaisseur, supérieure à 1 µm, est déposée afin de recouvrir, d'une part, sur la partie de gauche de la face FS, toute la région de contact 31 ainsi que la lame 2 et la seconde électrode 41, et d'autre part, la partie de droite de la face FS ainsi que la couche de résine 5, comme montré à la Fig. 4B.
C) La couche métallique 32,42 est usinée par gravure jusqu'à une épaisseur moyenne de 0,4 µm pour définir d'une part, le contour de la première région de connexion 32 et en particulier le bord latéral 34 de celle-ci sur la face supérieure 24 de la lame piézoélectrique, et d'autre part, les contours de l'ensemble pont 43 et seconde région de connexion 42, ce qui dégage une partie de la face supérieure 24 de la lame 2 et, le cas échéant, partiellement la face supérieure 413 de l'électrode 41, en laissant subsister l'extrémité de pont 431 sur la région 41, comme montré à la Fig. 4C.
D) La résine 5 localisée sous le pont de liaison 43 est finalement éliminée par dissolution, comme montré à la Fig. 4D.

La longueur du pont ainsi réalisé est inférieure à ou de l'ordre de 30 µm, ce qui lui confère une faible inductance et permet de relier la seconde électrode 41 ayant une surface faible à la région de connexion 42 offrant une surface nettement plus grande pour réaliser la liaison par soudure P2 au fil de connexion f2. En particulier pour une lame piézoélectrique à très fort coefficient de couplage, par exemple en nobiate de lithium, le transducteur 1 peut atteindre une admittance électrique proche de celle d'un générateur hyperfréquence classique, de l'ordre de 20x10⁻³S (Mhos), pour des hautes fréquences de quelques gigahertz. En outre, l'admittance du transducteur est peu modifiée du fait de la faible inductance série du pont de liaison "à air" 43, et une très bonne adaptation d'impédance peut être réalisée par simple accord.

Il est à noter que le transducteur piézoélectrique selon l'invention peut constituer par exemple un transducteur d'entrée ou un transducteur de sortie d'une ligne à retard à ondes de volume, ou l'unique transducteur d'une ligne à échos, ou l'unique transducteur d'un transducteur acousto-optique.

Dans le cas où la ligne acoustique comprend un substrat transparent, par exemple en quartz, et constitue un déflecteur acousto-optique, dit cellule de Bragg, pour lequel un faisceau laser est dirigé sous incidence de Bragg vers une grande face verticale latérale du substrat cristallin pour être défléchi par celui-ci, on obtient une bande passante en fréquence élargie. En effet, cette bande de fréquence est inversement proportionnelle à la largeur du faisceau acoustique se propageant dans le substrat qui est elle-même déterminée par les dimensions de la seconde électrode 41 disposée sur la lame piézoélectrique 2.

Pour obtenir une redondance, il est d'usage de prévoir plusieurs transducteurs ; c'est le cas notamment pour les cellules de Bragg.

Le procédé de fabrication de transducteur selon l'invention se prête bien à cette configuration.

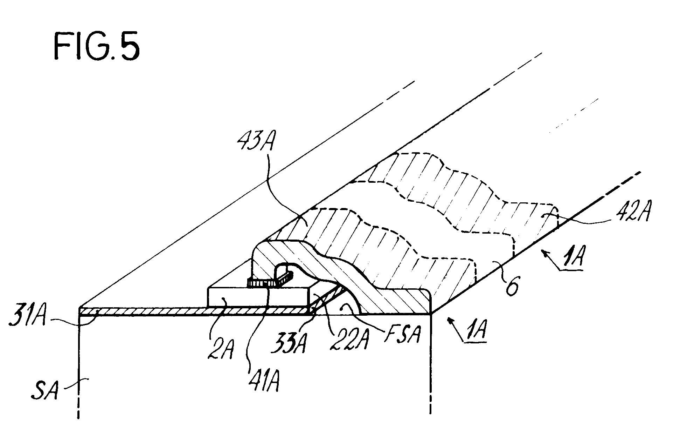

Comme représenté à la Fig. 5, plusieurs transducteurs piézoélectriques 1A comprennent en commun une unique première région de contact 31A disposée sur la face extrême FSA d'un substrat cristallin SA. Chaque transducteur 1A possède une lame piézoélectrique 2A et une seconde électrode 41A qui sont alignées transversalement à la face FSA et qui sont disposées d'une manière analogue à celle décrite pour le transducteur 1.

Des ponts de liaison 43A et des secondes régions de connexion 42A associées respectivement aux transducteurs 1A sont réalisés tout le long du bord 33A du plan de masse commun 33A et des côtés 22A des lames 2A selon les trois étapes successives A, B et C décrites précédemment. Avant l'étape D, une étape supplémentaire consiste à creuser la couche métallique 32,42 par gravure jusqu'à la couche de résine 5 et la face de substrat FS pour ménager des interstices de séparation 6 entre les ensembles à pont 43A et région de connexion 42A des transducteurs. Puis à l'étape D, la couche de résine 5 est éliminée, et les régions de connexion 42A avec les ponts 43A des transducteurs apparaissent juxtaposées perpendiculairement à la région de contact de masse 31A sur la face de substrat FSA.

## Revendications

1. Transducteur piézoélectrique comprenant une région de contact plane (31) d'une première électrode (3) disposée sur une face (FS) d'un support (S), une lame piézoélectrique (2) disposée sur la région de contact (31), et une seconde électrode (41) destinée à être reliée par soudure (P2) à un fil de connexion (f2), caractérisé en ce que la seconde électrode (41) est reliée à une première région de connexion (42) par un pont de liaison (43) enjambant un côté (22) de la lame piézoélectrique (2), ladite première région de connexion (42) étant disposée sur la face de support (FS) et supportant la soudure (P2) au fil de connexion (f2) et étant nettement plus grande que la seconde électrode (41), et en ce qu'il comprend une deuxième région de connexion (32) pour la première électrode (3) qui supporte une autre soudure (P1) à un autre fil de connexion (f1) et qui recouvre un côté (21) de la lame piézoélectrique (2) opposé audit côté (22) de la lame (2) enjambé par le pont de liaison (43), et partiellement la région de contact (31).

2. Transducteur conforme à la revendication 1, caractérisé en ce que la largeur du pont de liaison (43) est inférieure à la longueur (L) d'un côté (412) de la seconde électrode (41) enjambé également par le pont.

3. Transducteur conforme à l'une quelconque des revendications 1 et 2, caractérisé en ce que la seconde électrode (41) a une longueur (L) de l'ordre de ou inférieure à 30 µm, l'autre dimension de la seconde électrode (41) étant de l'ordre de 20 µm.

4. Transducteur conforme à l'une quelconque des revendications 1 à 3, caractérisé en ce que ledit côté (22) de la lame piézoélectrique (2) enjambé par le pont de liaison (43) est coplanaire à un bord (33) de la région de contact (31).

5. Ensemble de transducteurs piézoélectriques (1A), caractérisé en ce que lesdits transducteurs (1A) sont analogues à celui (1) conforme à l'une quelconque des revendications 1 à 4 et ont en commun une seule région de contact (31A), et en ce que les ponts de liaison (43A) et les régions de connexion (42A) des secondes électrodes (41A) des transducteurs sont juxtaposés parallèlement sur la face de support (FSA) et séparées par des interstices (6).

6. Procédé de fabrication d'un transducteur piézoélectrique conforme à l'une quelconque des revendications 1 à 5, caractérisé en ce que, après dépôt de la région de contact (31) de la première électrode (3) de la lame piézoélectrique (2) et de la seconde électrode (41), il comprend successivement :
A) Dépôt d'une couche de résine (5) partiellement sur la lame piézoélectrique (2) et la seconde électrode (41) et sur la face de support (FS) de part et d'autre du côté de lame (22) à enjamber par ledit pont (43),
B) Dépôt d'une couche métallique (32,42) pour recouvrir au moins la couche de résine (5) et une portion de la face de support (FS) non recouverte par la région de contact (31),
C) Usinage de la couche métallique (32,42) pour définir au moins le pont de liaison (43) et la région de connexion (42), reliée à la seconde électrode (41), et
D) Elimination de la couche de résine (5).

7. Procédé conforme à la revendication 6, caractérisé en ce que l'épaisseur moyenne de la couche métallique (32,42) après usinage est de l'ordre de 0,4 µm.

8. Procédé conforme à la revendication 6 ou 7, caractérisé en ce que la couche métallique (32,42) est egalement déposée sur la région de contact (31) et sur la lame piézoélectrique (2) et est usinée pour définir également une région de connexion (32) de la première électrode (3).

9. Procédé de fabrication de l'ensemble de transducteurs piézoélectriques conforme à la revendication 5, caractérisé en ce qu'il est analogue au procédé conforme à l'une quelconque des revendications 6 à 8, et en ce que l'usinage consiste également à creuser la couche métallique déposée (32,42) jusqu'à la couche de résine (5) et la face de support (FSA) afin de ménager lesdits interstices (6) entre des ensembles de pont de liaison (43A) et de région de connexion (42A) des secondes électrodes (41A) des transducteurs (1A).

## Claims

1. Piezoelectric transducer comprising a planar contact region (31) of a first electrode (3) arranged on one face (FS) of a support (S), a piezoelectric plate (2) arranged on the contact region (31), and a second electrode (41) intended to be linked by soldering (P2) to a connecting wire (f2), characterized in that the second electrode (41) is linked to a first connecting region (42) by a linking bridge (43) straddling one side (22) of the piezoelectric plate (2), the said first connecting region (42) being arranged on the support face (FS) and supporting the soldering (P2) to the connecting wire (f2) and being markedly larger than the second electrode (41), and in that it comprises a second connecting region (32) for the first electrode (3) which supports another soldering (P1) to another connecting wire (f1) and which covers one side (21) of the piezoelectric plate (2) opposite the said side (22) of the plate (2) straddled by the linking bridge (43), and partially the contact region (31).

2. Transducer in accordance with Claim 1, characterized in that the width of the linking bridge (43) is less than the length (L) of one side (412) of the second electrode (41) also straddled by the bridge.

3. Transducer in accordance with either of Claims 1 or 2, characterized in that the second electrode (41) has a length (L) of the order of or less than 30 µm, the other dimension of the second electrode (41) being of the order of 20 µm.

4. Transducer in accordance with any one of Claims 1 to 3, characterized in that the said side (22) of the piezoelectric plate (2) straddled by the linking bridge (43) is coplanar with one edge (33) of the contact region (31).

5. Set of piezoelectric transducers (1A), characterized in that the said transducers (1A) are similar to that (1) in accordance with any one of Claims 1 to 4 and have a single contact region (31A) in common, and in that the linking bridges (43A) and the connecting regions (42A) of the second electrodes (41A) of the transducers are juxtaposed parallel on the support face (FSA) and separated by interstices (6).

6. Method of fabricating a piezoelectric transducer in accordance with any one of Claims 1 to 5, characterized in that, after deposition of the contact region (31) of the first electrode (3) of the piezoelectric plate (2) and of the second electrode (41), it comprises successively:
A) Deposition of a layer of resin (5) partially on the piezoelectric plate (2) and the second electrode (41) and on the support face (FS) on either side of the plate side (22) to be straddled by the said bridge (43),
B) deposition of a metal layer (32, 42) in order to cover at least the layer of resin (5) and a portion of the support face (FS) not covered by the contact region (31),
C) machining of the metal layer (32, 42) in order to define at least the linking bridge (43) and the connecting region (42), linked to the second electrode (41), and
D) removal of the layer of resin (5).

7. Method in accordance with Claim 6, characterized in that the average thickness of the metal layer (32, 42) after machining is of the order of 0.4 µm.

8. Method in accordance with Claim 6 or 7, characterized in that the metal layer (32, 42) is also deposited on the contact region (31) and on the piezoelectric plate (2) and is machined also to define a connecting region (32) of the first electrode (3).

9. Method of fabricating the set of piezoelectric transducers in accordance with Claim 5, characterized in that it is similar to the method in accordance with any one of Claims 6 to 8, and in that the machining also consists in hollowing the deposited metal layer (32, 42) as far as the layer of resin (5) and the support face (FSA) so as to form the said interstices (6) between linking bridge assemblies (43A) and connecting region (42A) of the second electrodes (41A) of the transducers (1A).

## Patentansprüche

1. Piezoelektrischer Wandler mit einer ebenen Kontaktzone (31) einer ersten Elektrode (3), die auf einer Oberfläche (FS) eines Trägers (S) sitzt, einem piezoelektrischen Plättchen (2), das auf der Kontaktzone (31) sitzt, und einer zweiten Elektrode (41), die über einen Lötpunkt (P2) an einen Anschlußdraht (f2) angeschlossen werden soll, dadurch gekennzeichnet, daß die zweite Elektrode (41) mit einer ersten Anschlußzone (42) über eine Verbindungsbrücke (43) verbunden ist, die eine Seite (22) des piezoelektrischen Plättchens (2) überbrückt, wobei die erste Anschlußzone (42) auf der Oberfläche (FS) des Trägers liegt, den Lötpunkt (P2) des Anschlußdrahts (f2) trägt und deutlich größer als die zweite Elektrode (41) ist, und daß der Wandler eine zweite Anschlußzone (32) für die erste Elektrode (3) besitzt, die einen weiteren Lötpunkt (P1) zum Anschluß eines weiteren Anschlußdrahts (f1) trägt und eine Seite (21) des piezoelektrischen Plättchens (2), die der von der Verbindungsbrücke (43) überbrückte Seite (22) des Plättchens (2) gegenüberliegt, und teilweise die Kontaktzone (31) überdeckt.

2. Wandler nach Anspruch 1, dadurch gekennzeichnet, daß die Breite der Verbindungsbrücke (43) geringer als die Länge (L) einer ebenfalls von der Brücke überbrückten Seite (412) der zweiten Elektrode (41) ist.

3. Wandler nach einem beliebigen der Ansprüche 1 und 2, dadurch gekennzeichnet, daß die zweite Elektrode (41) eine Länge (L) in der Größenordnung von 30 mm oder weniger besitzt, während die andere Abmessung der zweiten Elektrode (41) in der Größenordnung von 20 µm liegt.

4. Wandler nach einem beliebigen der Ansprüche 1 bis 3, dadurch gekennzeichnet, daß die von der Verbindungsbrücke (43) überbrückte Seite (22) des piezoelektrischen Plättchens (2) in derselben Ebene wie ein Rand (33) der Kontaktzone (31) liegt.

5. Einheit von mehreren piezoelektrischen Wandlern (1A), dadurch gekennzeichnet, daß die Wandler (1A) den Wandlern (1) gemäß einem beliebigen der Ansprüche 1 bis 4 entsprechen und eine gemeinsame Kontaktzone (31A) besitzen und daß die Verbindungsbrücken (43A) und die Anschlußzonen (42A) der zweiten Elektroden (41A) der Wandler parallel nebeneinander auf der Oberfläche (FSA) des Trägers angeordnet sind und durch Abstände (6) voneinander getrennt sind.

6. Verfahren zur Herstellung eines piezoelektrischen Wandlers gemäß einem beliebigen der Ansprüche 1 bis 5, dadurch gekennzeichnet, daß nach dem Aufbringen der Kontaktzone (31) der ersten Elektrode (3), des piezoelektrischen Plättchens (2) und der zweiten Elektrode (41) folgende Verfahrensschritte nacheinander ablaufen:
A) Aufbringen einer Harzschicht (5) teilweise auf das piezoelektrische Plättchen (2) und die zweite Elektrode (41) sowie auf die Oberfläche (FS) des Trägers zu beiden Seiten des durch die Brücke (43) zu überbrückenden Rands (22) des Plättchens,
B) Aufbringen einer Metallschicht (32, 42), die zumindest die Harzschicht (5) und einen Teil der nicht von der Kontaktzone (31) bedeckten Oberfläche (FS) des Trägers bedeckt,
C) Abtragen der Metallschicht (32, 42), um mindestens eine Verbindungsbrücke (43) und die mit der zweiten Elektrode (41) verbundene Anschlußzone (42) zu definieren,
D) und Entfernung der Harzschicht (5).

7. Verfahren nach Anspruch 6, dadurch gekennzeichnet, daß die mittlere Dicke der Metallschicht (32, 42) nach dem Abtragen noch etwa 0,4 µm beträgt.

8. Verfahren nach Anspruch 6 oder 7, dadurch gekennzeichnet, daß die Metallschicht (32, 42) auch auf die Kontaktzone (31) und auf das piezoelektrische Plättchen (2) aufgebracht wird und dann abgetragen wird, um ebenfalls eine Anschlußzone (32) der ersten Elektrode (3) zu definieren.

9. Verfahren zur Herstellung einer Gruppe von piezoelektrischen Wandlern nach Anspruch 5, dadurch gekennzeichnet, daß es dem Verfahren gemäß einem der Ansprüche 6 bis 8 gleicht und daß das Abtragen auch darin besteht, die aufgebrachte Metallschicht (32, 42) bis auf die Harzschicht (5) und die Oberfläche (FSA) des Trägers abzutragen, um die Abstände (6) zwischen den aus einer Verbindungsbrücke (43A) und einer Anschlußzone (42A) der zweiten Elektrode (41A) der Wandler (1A) gebildeten Einheiten zu erzeugen.
